# EUROPÄISCHE PATENTSCHRIFT

(11) **EP 0 730 137 B1**
(45) Veröffentlichungstag und Bekanntmachung des Hinweises auf die Patenterteilung: **03.12.1997**
(21) Anmeldenummer: 96109083.4
(22) Anmeldetag: 01.07.1994
(51) Int. Cl.: G01D 5/18, G01B 7/00

(54) **Längen- oder Winkelmesseinrichtung**
Length or angle measuring device
Dispositif de mesure de longueurs ou d'angles

(43) Veröffentlichungstag der Anmeldung: 04.09.1996
(62) Teilanmeldung aus: 94110254.3
(73) Patentinhaber: Dr. Johannes Heidenhain GmbH, D-83292 Traunreut (DE)
(72) Erfinder: Speckbacher, Peter, Dr., 84558 Kirchweidach (DE)

(56) Entgegenhaltungen:
- EP-A- 0 442 329
- EP-A- 0 491 567
- DE-B- 2 720 869
- US-A- 4 767 973
- PATENT ABSTRACTS OF JAPAN vol. 017, no. 511 (E-1432), 14.September 1993 & JP-A-05 130618 (HAMAMATSU PHOTONICS KK), 25.Mai 1993,

## Beschreibung

Die Erfindung bezieht sich auf eine Längen- oder Winkelmeßeinrichtung mit einem Substrat als Maßverkörperung, welches Halbleiter-Bauelemente als Meßteilung trägt.

Aus der EP 0 588 383 A2 ist eine Positionsmeßeinrichtung bekannt, die den Halbleiter-Effekt dadurch ausnutzt, daß ein positionsabhängiges Signal erzeugt wird, wobei der Überdeckungsgrad eines beweglichen, ein Kraftfeld produzierenden Elementes gegenüber einer aktiven Oberfläche eines anderen Elementes positionsbestimmend ist.
Die EP 0 442 329 A1 offenbart ebenfalls eine Positionsmeßeinrichtung, die den Halbleitereffekt ausnutzt und bei der eine Abtastelektrode mit schleifendem Kontakt über ein Substrat geführt wird, um die Position zu bestimmen.

Aus der DE 27 20 869 B1 ist desweiteren eine Schieblehre bekannt, bei der eine Positionsinformation über einen Potentiometerabgriff erzeugt wird und die Anzeige der Position über eine Digitalanzeigeeinrichtung auf Seiten der Schieblehre erfolgt.

Ein Herstellverfahren für einen Sensor in integrierter Bauweise ist desweiteren aus der EP 0 491 567 A1 bekannt. Hierbei wird beschrieben, in einem Silizium-Substrat einen Sensorbereich freizuhalten und die Peripherie-Elektronik bereits bei der Fertigung des Substrates teilweise vorzubereiten, so daß eine sensorspezifische Fertigstellung des kompletten Bauelementes ohne großen Aufwand möglich ist.

Aufgabe der vorliegenden Erfindung ist es, eine besonders vorteilhafte Längen- oder Winkelmeßmeßeinrichtung zu schaffen, die den Feldeffekt in Halbleitern ausnutzt und eine einfache Herstellung auch in hohen Stückzahlen ermöglicht.

Diese Aufgabe wird durch eine Längen- oder Winkelmeßmeßeinrichtung mit den Merkmalen des Anspruches 1 gelöst.

Die besonderen Vorteile dieses Meßsystemes liegen in der Anwendung der Silizium-Technologie, was beispielsweise eine hohe Reproduzierbarkeit bei der Herstellung durch den hohen Reinheitsgrad des Si zur Folge hat. Zudem gewährleisten die bekannten Prozesse in der Halbleitertechnologie eine hohe Integrationsdichte und kleinste Strukturen im Submicronbereich. Die Verwendung von Feldeffekt-Transistor-Bauelementen als Meßteilung, die als aktivierbare Bauelemente bei der Positionsmessung elektrische Pulse erzeugen, ermöglicht die direkte Weiterverarbeitung dieser elektrischen Signale.

Mit Hilfe der Zeichnungen soll die Erfindung anhand eines Ausführungsbeispieles näher erläutert werden.

Es zeigt:
- Figur 1: eine Prinzipskizze;
- Figur 2: eine schematisierte Ausführungsform;
- Figur 3: eine Auswerteschaltung;
- Figur 4: eine Prinzipdarstellung eines Feldeffekt-Transistors;
- Figur 5: eine Meßeinrichtung mit Referenzmarken und ein Impulsdiagramm;
- Figur 6: eine Variante der Meßeinrichtung gemäß Figur 5;
- Figur 7: eine weitere Variante;
- Figur 8: eine Variante mit mehreren Referenzmarken und mehreren Steuer-Elektroden;
- Figur 9: eine unsymmetrische Impulsfolge und
- Figur 10: eine mehrspurige Meßeinrichtung als codierte Lagemeßeinrichtung.

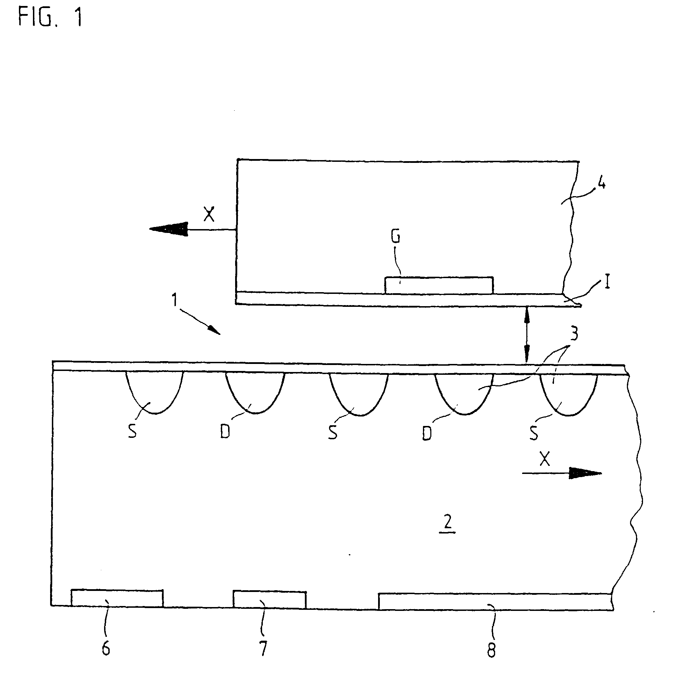

Die in Figur 1 dargestellte Prinzipskizze eines Längen- oder Winkelmeßsystemes 1 zeigt ausschnittsweise eine Maßverkörperung 2, die eine periodische Meßteilung 3 trägt. Die Meßteilung 3 besteht aus S-Polen (source) und D-Polen (drain) einer Reihe von Feldeffekt-Transistor-Bauelementen S und D, die als periodische Meßteilung 3 abwechselnd in Meßrichtung aneinandergereiht sind.

Diese Aneinanderreihung von Source- und Drain-Bereichen S und D wird bei Relativbewegungen zwischen der Maßverkörperung 2 und einer Abtasteinrichtung 4 abgetastet. Die Abtastung erfolgt mittels einer Steuer-Elektrode (gate) G, die sich in der Abtasteinrichtung 4 befindet. Die Steuer-Elektrode G bildet einen elektronenleitenden Kanal und überbrückt die Source- und Drain-Bereiche S und D der Meßteilung 3 und vervollständigt bzw. aktiviert damit jeweils die die Meßteilung 3 bildenden Feldeffekt-Transistor-Bauelemente S und D zu einem Feldeffekt-Transistor SDG.

Die Wirkungsweise des Meßsystems 1 beruht auf dem Schalten von einzelnen Transistor-Bauelementen, wobei abwechselnd die Source- und Drain-Bereiche S und D des Transistors periodisch als Maßverkörperung 2 in Silizium eindiffundiert sind und wobei auch ein anderes Halbleitersubstrat als Si denkbar ist.

Im Folgenden soll die Wirkungsweise anhand einer Prinzipdarstellung eines Feldeffekt-Transistors erläutert werden, da dieser Effekt für die Funktion der erfindungsgemäßen Meßeinrichtung anschaulich und wesentlich ist.

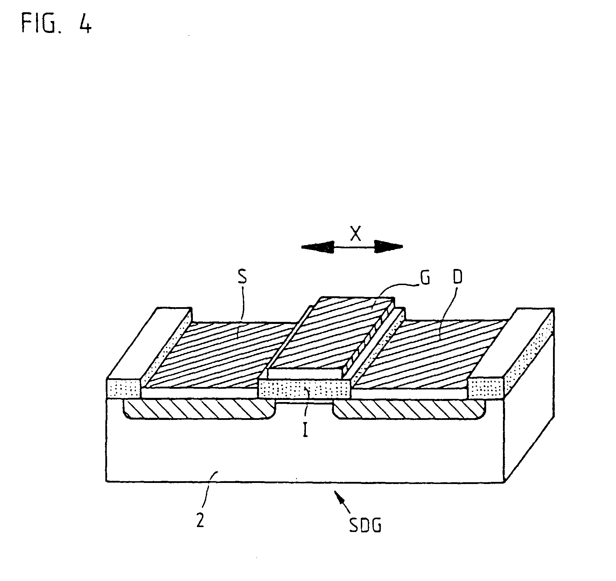

In Figur 4 ist beispielhaft ein einzelner Transistor SDG dargestellt, wobei das Substrat der Maßverkörperung 2 p-leitendes Silizium ist. Die Source- und Drain-Bereiche S und D sind stark n- dotiert. Die - beim Meßsystem bewegliche - einzelne Gateelektrode G (Metall) ist elektrisch durch einen Isolator I vom Substrat 2 getrennt und zur Meßteilung 3 relativ beweglich. Bei geeigneter Gatespannung kann der Bereich unter dem Gate G zwischen Source S und Drain D mit Elektronen verarmt bzw. angereichert werden. Bei Anlegen einer genügend hohen positiven Gatespannung entsteht zwischen Source S und Drain D ein elektronenleitender Kanal, die "Inversionsschicht", der Transistor SDG wird in diesem Fall in Sättigung betrieben. Der Betrieb des Meßsystems ist außer im Sättigungsbereich aber auch im Verstärkungsbereich des Transistors SDG möglich, was später noch ausführlich abgehandelt wird.

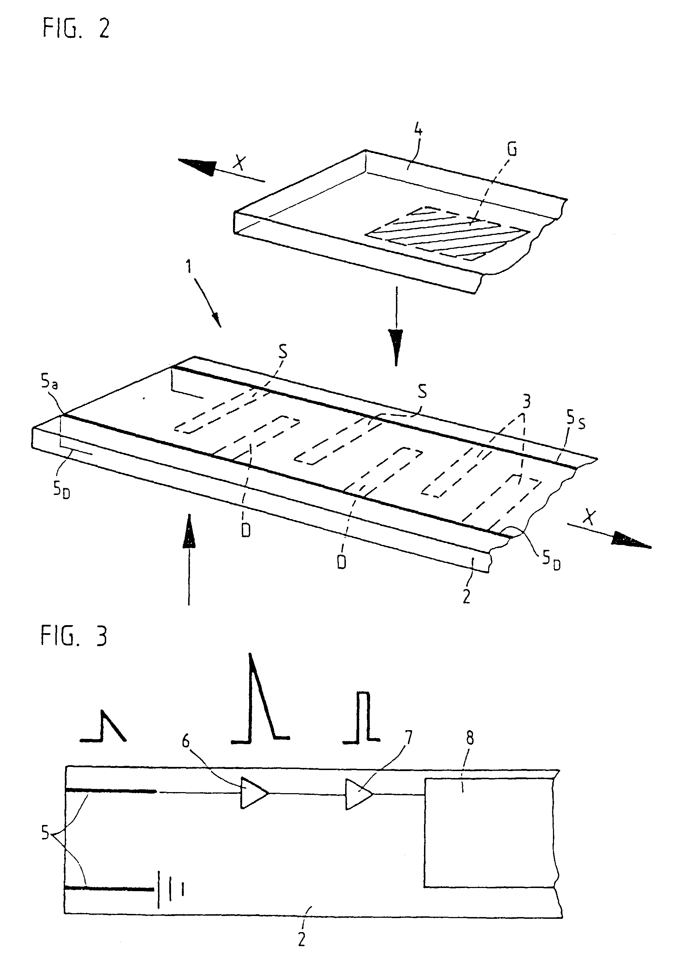

In Figur 2 ist eine mögliche, schematisierte Ausführungsform gezeigt. Die Bezugszeichen gemäß Figur 1 werden beibehalten, jedoch soll durch die perspektivische Darstellung der Bezug zu herkömmlichen Längen- oder Winkelmeßeinrichtungen erleichtert werden.

Die Maßverkörperung 2 wird beschrieben durch periodisches aber abwechselndes Aneinanderreihen von Source- und Drain-Bereichen S und D in Meßrichtung. Die Source- und Drainimplantation ist in der Halbleitertechnologie ein Standardprozeß, wobei Strukturen im Submicronbereich Stand der Technik sind. Als Beispiele für Aneinanderreihen von Transistoren seien Flüssigkeitsanzeigen "LCD" oder "CCD"-Zeilenkameras genannt. Die Source- und Drainimplantation beeinflußt die Oberflächenplanheit der Maßstabsoberfläche nicht. Zur Passivierung und Erhöhung der mechanischen Belastbarkeit kann die Maßstabsoberfläche mit SiO₂ oder Si₃N₄ belegt werden.

Die Abtasteinheit 4 besteht ebenfalls aus Silizium, in welches eine oder mehrere Gateelektroden G integriert sind. Möglich ist auch ein Tieferlegen der Gatestruktur zum Beispiel durch selektive Ätzprozesse in Silizium. Die Abtasteinheit 4 und der Maßstab 2 können in Kontakt oder in einem definiertem Abstand gegeneinander geführt werden. Bei Bewegung von Abtasteinheit 4 (Gateelektrode G) und Maßstab 2 in einem definiertem Abstand muß je nach Substratdotierung und angelegter Gatespannung ein definierter Abstand eingehalten werden, um den elektronenleitenden Kanal zu erhalten. Der Körper 2 wird als Teilabschnitt einer Maßverkörperung betrachtet, die bereits in den Figuren 1 und 2 gezeigt ist. Zwischen zwei dotierten Bereichen S und D, die zwei Pole eines Feldeffekt-Transistors SDG darstellen, wird ein Bereich plaziert, der das Gatter (gate) G des vorgenannten Transistors SDG bildet.

Ein weiterer nennenswerter Vorteil der Erfindung ist folgender:

Durch die Verwendung von Transistoren SDG als aktivierbare Bauelemente zur Längenmessung, können elektrische Pulse direkt weiter verarbeitet werden. Hierzu können zum Beispiel durch anisotrope Ätzprozesse in Silizium, die elektrischen Verbindungen von aktiver Maßstabsoberfläche und weiterverarbeitender Elektronik auf der Rückseite des Maßstabes 2 durch in Gräben 5a tiefergelegte Leiterbahnen 5 hergestellt werden. Auf der Rückseite des Maßstabsubstrates 2 können wahlweise Bauelemente für die Signalverarbeitung (Verstärker 6, Signalvervielfachung 7) und die Ausleseeinheit 8 (z.B. optische LCD-Anzeige) integriert sein. Für den Herstellungsprozeß sind sogenannte "batch" Prozesse denkbar, um hohe Stückzahlen zu erreichen. Hierbei werden auf ein und demselben Substrat eine möglichst große Zahl von identischen Meßsystemen 1 gleichzeitig hergestellt.

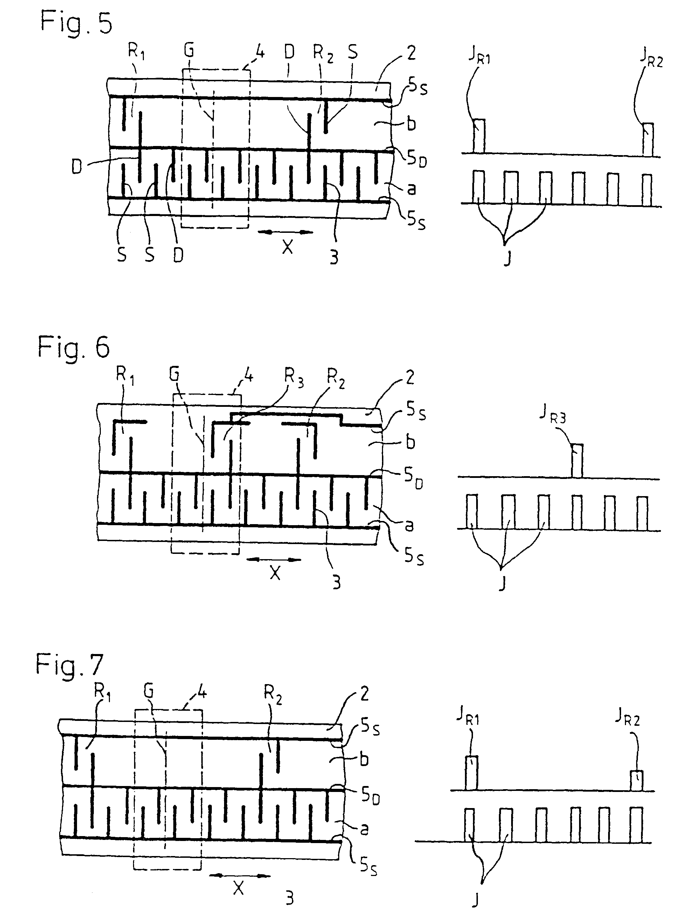

In den Figuren 5 bis 10 ist jeweils in stark schematisierter Darstellung eine vorteilhafte Ausführungsform gezeigt, deren Beschreibung nun folgt. Dabei liegt jeweils die Darstellungsweise in den Figuren 1 und 2 zugrunde, so daß auf die flächige Darstellung der Source- und Drain-Bereiche und der Steuer-Elektrode zugunsten der einfacheren Strichdarstellung verzichtet wurde.

Figur 5 zeigt eine Maßverkörperung 2, auf deren Substrat zwei Spuren a und b angeordnet sind. Spur a weist in Meßrichtung X abwechselnd Source- und Drain-Bereiche S und D auf, die sich jeweils von einer gemeinsamen Sammelleitung 5_{S} bzw. 5_{D} senkrecht zur Meßrichtung X erstrecken und die eine Inkremental-Teilung als Meßteilung 3 bilden.

In der Spur b befinden sich an ausgewählten Orten - in gleicher Weise wie die Meßteilung 3 auf dem Substrat 2 aufgebracht - Source- und Drain-Bereiche S und D, die zwei Referenzmarken R₁ und R₂ bilden.

Mit gestrichelten Linien ist eine Abtasteinrichtung 4 gezeigt, die eine Steuer-Elektrode G beinhaltet.

Bei Relativbewegungen von Substrat 2 und Abtasteinrichtung 4 in Meßrichtung X entstehen beim Überfahren der Source- und Drain-Bereiche S und D Impulse J (von der inkrementalen Meßteilung 3) und J_{R1}, J_{R2} (von den Referenzmarken R₁ und R₂). Das entsprechende Impulsdiagramm ist vereinfacht im rechten Teil von Figur 5 gezeigt.

Figur 6 zeigt eine ähnliche Anordnung wie Figur 5. Dort sind in gleicher Weise drei Referenzmarken R₁, R₂, R₃ auf dem Substrat 2 aufgebracht. Aus betriebstechnischen Gründen sollen jedoch nicht alle Referenzmarken R₁, R₂ und R₃ ausgewählt werden. Für den hier beschriebenen Fall soll lediglich eine Referenzmarke, nämlich R₃ aktiviert werden. Das kann durch eine entsprechende Verschaltung der Referenzmarken R₁, R₂, R₃ geschehen. In diesem Beispiel wird die Source-Sammelleitung 5_{S} zur Referenzmarke R₃ geführt, die Source-Verbindung zu den Referenzmarken R₁ und R₂ ist unterbrochen. Dadurch können diese beim Überfahren mit der Steuer-Elektrode G nicht aktiviert werden. Aus dem nebenstehenden Impulsdiagramm wird dies auch ersichtlich.

Eine Referenzmarkenauswahl kann auch dadurch erfolgen, daß bei der Auswertung verschiedene Referenzmarken in unterschiedlichen Verstärkungsbereichen betrieben werden. Dies ist mit Hilfe von Figur 7 dargestellt, und insbesondere aus dem zugehörigen Impulsdiagramm ersichtlich. Die unterschiedliche Höhe der Impulse J_{R1} und J_{R2} entsteht durch den Betrieb in unterschiedlichen Verstärkungsbereichen. Durch entsprechende Schwellwertschalter oder dergleichen, kann eine Referenzmarkenauswahl erfolgen. Das gleiche Bild ergibt sich, wenn die verschiedenen Referenzmarken mit unterschiedlichen Vorspannungen ihrer Source- und Drain-Bereiche betrieben werden.

Selbstverständlich müssen dazu die Sammelleitungen zu den Referenzmarken unterbrochen sein. Dieses Ausführungsbeispiel wird aber nicht zeichnerisch dargestellt, weil das Impulsdiagramm dem aus Figur 7 gleichen würde.

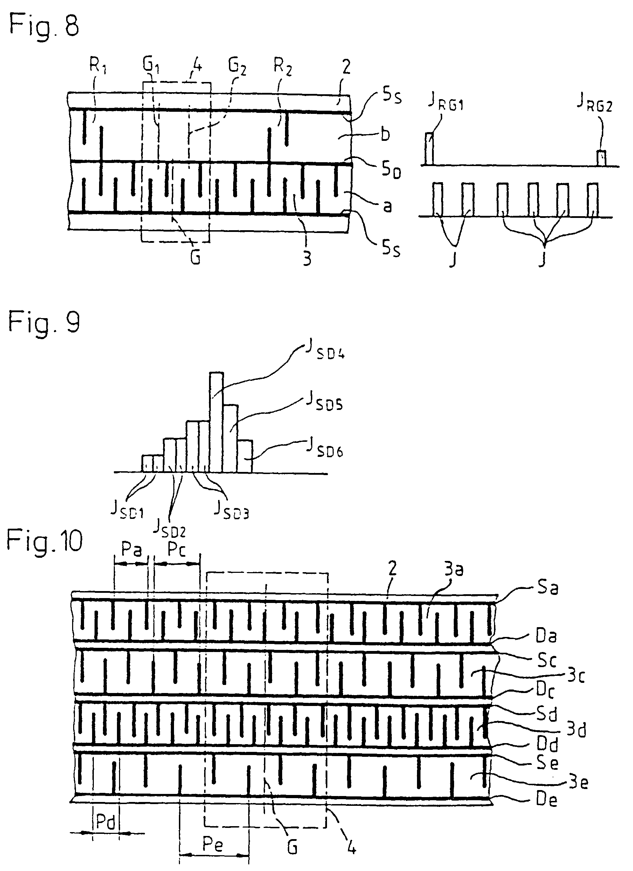

Eine andere Lösung zur Auswahl von Referenzmarken R₁ oder R₂ aus einer beliebigen Anzahl von Referenzmarken ist im Ausführungsbeispiel gemäß Figur 8 dargestellt.

In der Abtasteinrichtung 4 sind außer der Steuer-Elektrode G für die Meßteilung 3 noch zwei weitere Steuer-Elektroden G1 und G2 vorgesehen. Mit diesen Steuer-Elektroden G1 und G2 können gezielt einzelne Referenzmarken R₁ bzw. R₂ ausgewählt werden. Auch bei dieser Ausführungsform können die Steuerspannungen, die Vorspannungen der Source- und Drain-Bereiche, die Verstärkungsbereiche beliebig variiert werden, auch Kombinationen dieser Variationen sind selbstverständlich möglich. Das Impulsdiagramm kann dem dargestellten entsprechen. Die durch den räumlichen Versatz der Steuer-Elektroden G1 und G2 auftretenden Lageänderungen der Impulse können gezielt genutzt werden, aber sie können auch durch entsprechenden Versatz der Referenzmarken auf dem Substrat wieder ausgeglichen werden.

Eine weitere sehr vorteilhafte Möglichkeit zur Auswertung von Referenzmarken wird anhand eines Impulsdiagrammes in Figur 9 veranschaulicht.

Eine nicht dargestellte Referenzmarke weist dazu mehrere Source- und Drain-Bereiche auf. Hierdurch unterscheidet sich ihr Aufbau von dem der bisher betrachteten Referenzmarken.

Einige der Source- und Drain-Bereiche können schaltungstechnisch zusammengefaßt werden, aber es kann zwischen oder neben zusammengefaßten Source- und Drain-Bereichen auch ein einzelner Source- und Drain-Bereich angeordnet sein.

Analog zu den vorbeschriebenen Ausführungsbeispielen können sowohl die zusammengefaßten, als auch die einzelnen Source- und Drain-Bereiche mit unterschiedlichen Vorspannungen und/oder in unterschiedlichen Verstärkungsbereichen betrieben werden. Ein derartiger Betrieb kann eine Impulsfolge erzeugen, wie sie in Figur 9 dargestellt ist. Dabei bedeutet J_{SD1}, daß ein Impuls vorliegt, der aus zwei zusammengefaßten Source- und Drain-Bereichen einer ersten Vorspannung (oder eines ersten Verstärkungsbereiches) hervorgegangen ist. Der Impuls J_{SD2} ist aus zwei zusammengefaßten Source- und Drain-Bereichen einer zweiten Vorspannung (oder eines zweiten Verstärkungsbereiches) hervorgegangen. Dementsprechend ist der Impuls J_{SD3} aus (wiederum zwei) zusammengefaßten Source- und Drain-Bereichen einer dritten Vorspannung (oder eines dritten Verstärkungsbereiches) hervorgegangen. Daran schließen sich Impulse J_{SD4}, J_{SD5} und J_{SD6} an, die jeweils an einzelnen Source- Drain-Bereichen gewonnen werden, aber mit unterschiedlichen vierten, fünften und sechsten Vorspannungen oder entsprechenden Verstärkungsbereichen betrieben werden.

Wenn eine solche Impulsfolge ausgewertet wird, zeigt sich, daß die Einhüllende eine unsymmetrische Kurve ist. Deren Auswertung kann vorteilhaft zur Erkennung der Richtung herangezogen werden, aus der die so gestaltete Referenzmarke überfahren wurde.

Derartig unsymmetrische Referenzmarken lassen sich besonders vorteilhaft als Grenzlagenschalter verwenden.

Figur 10 zeigt schließlich ein Ausführungsbeispiel, bei dem auf einem Substrat 2 mehrere Spuren a, c, d, e vorgesehen sind. In jeder Spur a, c, d und e befinden sich abwechselnde Source- und Drain-Bereiche, die periodisch angeordnet sind und jeweils eine periodische Meßteilung 3a, 3c, 3d und 3e bilden. Diese Meßteilungen 3a, 3c, 3d und 3e sind zwar periodisch, aber jede der Meßteilungen 3a, 3c, 3d und 3e hat eine andere Teilungsperiode Pa, Pc, Pd, Pe.

Bei gemeinsamer Abtastung aller Meßteilungen 3a, 3c, 3d, 3e mit einer einzigen Steuer-Elektrode G in einer Abtasteinrichtung 4 kann aus der Phasenbeziehung der Abtastsignale ein codierter Positionswert gewonnen werden.

Die technische Ausführungsform entspricht beispielsweise vier parallelen Meßeinrichtungen gemäß Figur 2, entsprechend sind die Source- und Drain-Sammelleitungen bezeichnet. Eine Analogie zu den vorstehenden Ausführungsbeispielen ist für den Fachmann ohne weiteres herleitbar, so daß die Grund-Funktionsprinzipien nicht noch einmal erläutert werden müssen.

Zusammengefaßt beruht das beschriebene Meßsystem 1 darauf, das feldinduziert in einem Halbleiter, je nach örtlicher Position der Gateelektrode G, eine elektronenleitende Inversionsschicht ein und ausgeschaltet wird.

Das oben beschriebene System ist unabhängig von optischen Signalen und Bauelementen. Damit ist keine "Alterung" des Meßsystems 1 mit der Zeit zu erwarten (Abbau der Intensitäten von Laserdioden mit langen Betriebszeiten). Das oben beschriebene Meßsystem 1 kann als Längenmeßsystem oder als Winkelmeßsystem ausgeführt werden.

Durch die Verwendung von Silizium sind bekannte Halbleitertechnologien und Prozesse verwendbar, eine Integration von Optik, Elektronik und Mechanik zu einem Mikrosystem ist denkbar.

Silizium hat hervorragende mechanische Eigenschaften, wie zum Beispiel Kratzfestigkeit. Die Reinheit des Kristalls gewährt hohe Reproduzierbarkeit der elektronischen Eigenschaften des Meßsystems.

Bei Verwendung von anderen Halbleitermaterialien sind hohe Grenzfrequenzen der schaltenden Transistoren SDG zu erwarten. Als Beispiel sei ein HEMT ("high-electron-mobility-transistor") Transistor mit einer Schichtstruktur von GaAs/GaALAs erwähnt, wobei Grenzfrequenzen bis 100 GHz erreicht werden.

## Patentansprüche

1. Längen- oder Winkelmeßeinrichtung mit einem Substrat (2) als Maßverkörperung, welches Halbleiter-Bauelemente (S, D) als Meßteilung (3) trägt, die von einer Abtasteinrichtung (4) abgetastet werden, und bei der auf dem Substrat (2) wenigstens eine Spur (a) vorhanden ist, in der die Meßteilung (3) durch eine Vielzahl von in Meßrichtung X periodisch hintereinander angeordneten Source-Bereichen (S) und eine Vielzahl von ebenfalls in Meßrichtung X periodisch hintereinander angeordneten Drain-Bereichen (D) gebildet wird, wobei die Source (S)- und Drain (D)-Bereiche quer zur Meßrichtung X nach Art von Zinken abwechselnd ineinander greifen, und daß zur Abtastung der so gebildeten Meßteilung (3) in der Abtasteinrichtung (4) wenigstens eine Steuer-Elektrode (G) vorhanden ist, die in Meßrichtung X, parallel zur Oberfläche in konstantem Abstand des Substrates (2) verschiebbar ist, wobei in das Substrat (2) Bauelemente (6, 7, 8) für die Signalverarbeitung integriert sind.

2. Längen- oder Winkelmeßeinrichtung nach Anspruch 1, in welcher in das Substrat (2) ein Verstärker (6) integriert ist.

3. Längen- oder Winkelmeßeinrichtung nach Anspruch 1, in welcher in das Substrat (2) ein Bauelement zur Signalvervielfachung (7) integriert ist.

4. Längen- oder Winkelmeßeinrichtung nach Anspruch 1, in welcher in das Substrat (2) ferner eine Ausleseeinheit (8) integriert ist.

5. Längen- oder Winkelmeßeinrichtung nach Anspruch 4, in welcher die Ausleseeinheit (8) als optische LCD-Anzeige ausgebildet ist.

6. Längen- oder Winkelmeßeinrichtung nach einem der Ansprüche 1 - 5, in welcher die Bauelemente (6, 7, 8) in die Rückseite des Substrates (2) integriert sind.

7. Längen- oder Winkelmeßeinrichtung nach Anspruch 1, in welcher die Bauelemente (6, 7, 8) mit den Source- und Drain-Bereichen (S, D) innerhalb des Substrates (2) elektrisch verbunden sind.

8. Längen- oder Winkelmeßeinrichtung nach Anspruch 7, in welcher durch anisotropes Ätzen von Gräben (5a) in das Substrat (2) und galvanische Leiterbahn-Verbindungen (5) in den Gräben (5a) die Verbindung der Bauelemente (6, 7, 8) mit den Source- und Drain-Bereichen (S, D) hergestellt ist.

## Claims

1. Length or angle measuring device with a substrate (2) as a material measure, which carries semiconductor components (S,D) as a measurement division (3), which are scanned by a scanner (4) and in which there is present on the substrate (2) at least one track (a), in which the measurement division (3) is formed by a plurality of source areas (S) located periodically in succession in the measurement direction (X) and a plurality of drain areas (D) likewise located periodically in succession in the measuring direction (X), the source (S) and drain (D) areas engaging alternately in one another transversely to the measurement direction (X) in the manner of tines, and in that, in order to scan the measurement division (3) so formed, there is present in the scanner (4) at least one control electrode (G), which is displaceable in the measurement direction (X) parallel to the surface at a constant spacing from the substrate (2), components (6, 7, 8) for signal processing being integrated in the substrate (2).

2. Length or angle measuring device according to claim 1, in which an amplifier (6) is integrated in the substrate (2).

3. Length or angle measuring device according to claim 1, in which a component for signal multiplication (7) is integrated in the substrate (2).

4. Length or angle measuring device according to claim 1, in which a read-out unit (8) is also integrated in the substrate (2).

5. Length or angle measuring device according to claim 4, in which the read-out unit (8) is in the form of an optical LCD display.

6. Length or angle measuring device according to one of claims 1 to 5, in which the components (6, 7, 8) are integrated in the rear side of the substrate (2).

7. Length or angle measuring device according to claim 1, in which the components (6, 7, 8) are electrically connected to the source and drain areas (S, D) within the substrate (2).

8. Length or angle measuring device according to claim 7, in which connection of the components (6, 7, 8) is established with the source and drain areas (S, D) by means of anisotropic etching of troughs (5a) in the substrate (2) and electroplated conductor track connections (5) in the troughs (5a).

## Revendications

1. Dispositif de mesure de longueurs et d'angles, comportant, en tant que mesure matérialisée, un substrat (2) qui porte, comme graduation de mesure (3), des composants semi-conducteurs (S, D) qui sont palpés par un dispositif de palpage (4), dans lequel il est prévu, sur le substrat (2), au moins une piste (a) à l'intérieur de laquelle la graduation de mesure (3) est formée de plusieurs zones-source (S) disposées périodiquement les unes à la suite des autres dans la direction de mesure X et de plusieurs zones de drain (D) également disposées périodiquement les unes à la suite des autres dans la direction de mesure X, les zones de source (S) et de drain (D) s'interpénétrant alternativement, à la manière de dents, transversalement à la direction de mesure X, au moins une électrode de commande (G) étant prévue dans le dispositif de palpage (4) pour le palpage de la graduation de mesure (3) ainsi formée, laquelle électrode peut se déplacer dans la direction de mesure X, parallèlement à la surface du substrat (2) et à distance constante de celui-ci, des composants (6, 7, 8) pour le traitement du signal étant intégrés dans le substrat (2).

2. Dispositif de mesure de longueurs et d'angles selon la revendication 1, dans lequel un amplificateur (6) est intégré dans le substrat (2).

3. Dispositif de mesure de longueurs et d'angles selon la revendication 1, dans lequel un composant pour la multiplication du signal (7) est intégré dans le substrat (2).

4. Dispositif de mesure de longueurs et d'angles selon la revendication 1, dans lequel une unité de sélection (8) est intégrée dans le substrat (2).

5. Dispositif de mesure de longueurs et d'angles selon la revendication 4, dans lequel l'unité de sélection (8) est agencée sous forme d'affichage optique à DEL.

6. Dispositif de mesure de longueurs et d'angles selon une des revendications 1-5, dans lequel les composants (6, 7, 8) sont intégrés dans la face arrière du substrat (2).

7. Dispositif de mesure de longueurs et d'angles selon la revendication 1, dans lequel les composants (6, 7, 8) sont connectés électriquement aux zones source et drain (S, D) à l'intérieur du substrat (2).

8. Dispositif de mesure de longueurs et d'angles selon la revendication 7, dans lequel la connexion des composants (6, 7, 8) aux zones source et drain (S, D) est réalisée par formation de sillons (5a) dans le substrat (2) par attaque anisotropique et par formation de pistes conductrices (5) de liaison galvaniques dans les sillons (5a).
